# EUROPÄISCHE PATENTSCHRIFT

(11) **EP 1 550 176 B1**
(45) Veröffentlichungstag und Bekanntmachung des Hinweises auf die Patenterteilung: **05.11.2008**
(21) Anmeldenummer: 03750691.2
(22) Anmeldetag: 07.10.2003
(51) Int. Cl.: H01Q 1/38, H01Q 1/22, H01Q 23/00, H01Q 7/00

(54) **ELEKTRONISCHE SCHALTUNGSANORDNUNG MIT INTEGRIERTER ANTENNE**
ELECTRONIC CIRCUITRY PROVIDED WITH AN INTEGRATED ANTENNA
ENSEMBLE CIRCUIT ELECTRONIQUE A ANTENNE INTEGREE

(30) Priorität: 08.10.2002 DE 10246953
(43) Veröffentlichungstag der Anmeldung: 06.07.2005
(73) Patentinhaber: Leopold Kostal GmbH & Co. KG, 58507 Lüdenscheid (DE)
(72) Erfinder: FROMM, Michael, 44289 Dortmund (DE); PRETZLAFF, Volker, 58093 Hagen (DE); VENS, Rainer, 44139 Dortmund (DE)
(86) Internationale Anmeldenummer: PCT/EP2003/011050
(87) Internationale Veröffentlichungsnummer: WO 2004/034512

(56) Entgegenhaltungen:
- EP-A- 0 669 672
- EP-A- 1 189 304
- EP-A- 1 349 109
- WO-A-89/04880
- US-A- 4 894 663
- US-A1- 2002 089 454
- PATENT ABSTRACTS OF JAPAN vol. 1997, no. 12, 25. Dezember 1997 (1997-12-25) & JP 09 214389 A (MITSUBISHI ELECTRIC CORP), 15. August 1997 (1997-08-15)

## Beschreibung

Die Erfindung betrifft eine elektronische Schaltungsanordnung, umfassend eine Leiterplatte mit einer Oberseite, einer Unterseite sowie Seitenflächen, auf der ein eine Sende- und/oder Empfangseinrichtung beinhaltendes Bauteil und eine an dasselbe angeschlossene Antenne angeordnet sind, wobei die Antenne bezogen auf ihre Längserstreckung zumindest abschnittsweise an mehreren Seitenflächen der Leiterplatte diese aussenseitig abdeckend angeordnet und über zumindest eine Anschlußleiterbahn mit dem die Sende- und/oder Empfangseinrichtung beinhaltenden Bauteil elektrisch verbunden ist.

Derartige elektronische Schaltungsanordnungen werden beispielsweise eingesetzt bei Handsendern, etwa für Garagentüröffner, Funkfernbedienungen für Kraftfahrzeuge oder sonstige Anwendungen. Diese Schaltungsanordnungen umfassen eine Leiterplatte, auf der neben anderen elektrischen/elektronischen Bauteilen auch ein Sende- und/oder Empfangsbauteil angeordnet sind. Die Antenne ist bei solchen Schaltungsanordnungen durch eine auf der Ober- oder Unterseite der Leiterplatte aufgebrachte Leiterbahnstruktur gebildet. Um die Leiterplattengröße nicht unnötig groß vorsehen zu müssen, ist die Antennenstruktur um andere elektrisch/elektronische Bauteile herumgeführt, die sodann in unmittelbarer Nähe angeordnet und auch zum Teil von der Antennenstruktur eingeschlossen sind. Zwar kann durch eine solche Anordnung der Antenne die Antennenstruktur zwar grundsätzlich in das Leiterbahnlayout mit eingebracht werden, jedoch ist bei einer Konzeption des Leiterbahnlayouts zu berücksichtigen, daß die Antennenstruktur von anderen Leiterbahnen nicht kontaktiert werden darf. Die Nähe von elektrischen/elektronischen Bauteilen zu der an diesen Bauteilen vorbeigeführten Antennenleiterbahnstruktur hat zur Folge, dass durch diese die Antenne verstimmt werden kann, was sich nachteilig auf die Sende-Empfangsqualität auswirkt.

Im Zuge einer weiter zunehmenden Miniaturisierung und einer steigenden funktionalen Komplexität derartiger Schaltungsanordnungen stellt jedoch die Unterbringung der Antennenstruktur auf der Leiterplatte ein nicht unerhebliches, diesen Bestrebungen entgegenstehendes Problem dar.

In der US-Patentanmeldung 2002/0089454 A1 ist auf einem unter anderem eine Mobilfunk Sende-Empfangseinrichtung aufweisenden, als gedruckte Leiterplatte ausgebildeten ersten Substrat eine Antennenanordnung montiert. Dabei sind die die eigentliche Antenne bildenden leitfähigen Strukturen auf einem mit der Leiterplatte flächig verbundenen zweiten Substrat aufgebracht. Teile der leitfähigen Strukturen der Antenne sind dabei auch auf den Seitenflächen des zweiten Substrats angeordnet.

Die europäische Patentanmeldung EP 0 669 672 A1 offenbart ein tragbares Funkgerät mit einer aus einem Blechteil geformten Schlitzantenne. Diese ist im Bereich einer Stirnseite der Leiterplatte angeordnet.

Die europäische Patentanmeldung EP 1 189 304 A2 betrifft ein Einschubgerät für einen Computer mit einer Funkübertragungskarte. Die Antenne für diese Funkübertragungskarte ist hierbei nicht auf demselben Substrat wie die Sende-/Empfangseinrichtung angeordnet sondern auf einem seoparaten Substrat, welches über eine Steckverbindung mit dem ersten Substrat elektrisch verbindbar ist.

Die US-Patentanmeldung 4,894,663 offenbart ein gehäuse mit einer auf die Seitenflächen geduckten Antenne.

Ausgehend von diesem diskutierten Stand der Technik liegt der Erfindung daher die Aufgabe zugrunde, eine eingangs genannte, gattungsgemäße elektronische Schaltungsanordnung dergestalt weiterzubilden, dass nicht nur die Antennencharakteristik weitestgehend unbeeinflußt von weiteren, auf der Leiterplatte angeordneten elektrischen/elektronischen Bauteilen ist, sondern dass insbesondere die notwendige räumliche Unterbringung der Antenne bzw. der Antennenstruktur auf der Leiterplatte einer zunehmend gewünschten höheren Bestückungsdichte nicht entgegensteht.

Diese Aufgabe wird erfindungsgemäß dadurch gelöst, dass die Antenne durch eine galvanische Kupferbeschichtung der Seitenflächen der Leiterplatte gebildet ist, und eine Querschnitts-fläche wie in den Ansprüchen 1 und 2 definiert aufweist.

Bei dieser Schaltungsanordnung ist die Antenne zumindest abschnittsweise, zweckmäßigerweise jedoch mit ihrer im wesentlichen gesamten Erstreckung an mehreren Seitenflächen der Leiterplatte hinweg erstreckend angeordnet. Durch die Anordnung der Antenne an den durch die Stärke bzw. Dicke der Leiterplatte gebildeten Seitenflächen derselben ist nicht nur die durch die Antennenstruktur aufgespannte Antennenfläche maximiert, sondern insbesondere befindet sich die Antenne in einem Bereich der Leiterplatte, in dem ohnehin keine elektrischen/elektronischen Bauteile angeordnet werden können. Bei Konzeption einer Antenne, die sich über alle Seitenflächen der Leiterplatte hinweg erstreckt, ist nicht nur eine maximale Antennenfläche aufgespannt, sondern insbesondere ist die Antenne bezüglich ihrer Abstrahl- oder Empfangswirkung auch nicht durch andere Bauteile oder Bauelemente der Leiterplatte abgeschirmt. Ferner kann der Abstand der Antenne zu weiteren, auf der Leiterplatte befindlichen Bauteilen maximiert sein, so daß der Einfluß von solchen Bauteilen auf die Antennencharakteristik minimiert ist. Das Leiterbahn- und Bestückungslayout der Ober- und/oder Unterseite der Leiterplatte kann sodann grundsätzlich ohne mögliche Rücksichtnahme auf eine Unterbringung der Antennenstruktur erfolgen.

Die Erfindung ist nachfolgend anhand von Ausführungsbeispielen unter Bezugnahme auf die beigefügten Figuren beschrieben. Es zeigen:
- **Fig. 1:**: Eine schematisierte Draufsicht auf eine auf einer Leiterplatte aufgebaute und als Transponder ausgebildete elektronische Schaltungsanordnung,
- **Fig. 2:**: Einen vergrößerten Teillängsschnitt durch die elektronische Schaltungsanordnung der Figur 1 entlang der in dieser Figur gezeigten Linie A-B und
- **Fig. 3:**: Eine Darstellung entsprechend Figur 2, darstellend den Randbereich einer weiteren Leiterplatte mit einer Antenne.

Eine elektronische Schaltungsanordnung 1 umfaßt eine Leiterplatte 2 als Träger mehrerer elektronischer Bauteile B₁, B₂ und B₃ sowie eine Sende-Empfangseinrichtung 3. Die Leiterplatte 2 ist ferner Träger für eine Antenne 4, die über Anschlußleiterbahnen 5, 5' an die Sende-Empfangseinrichtung 3 angeschlossen ist.

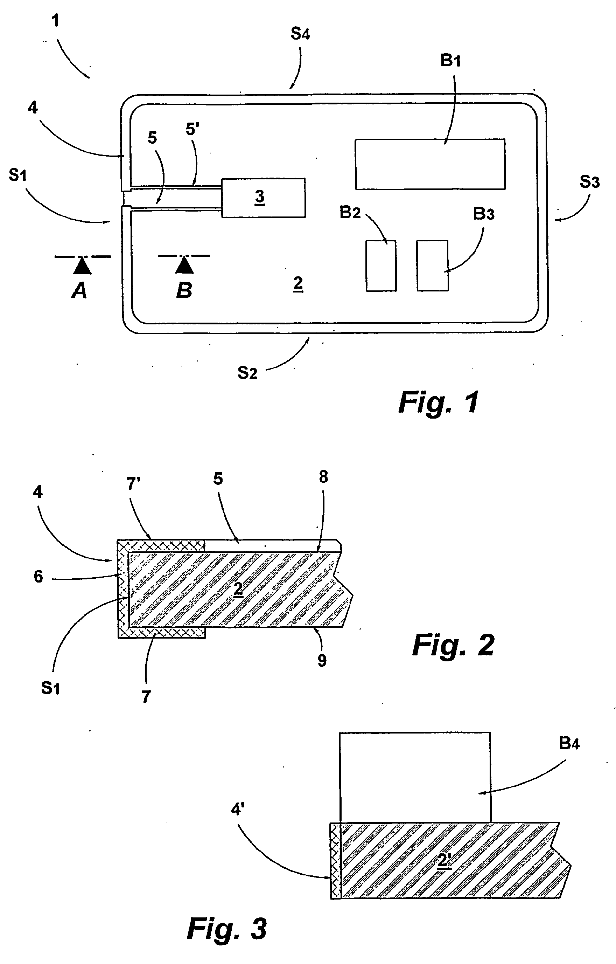

Die Antenne 4 ist den durch die Materialstärke der Leiterplatte 2 gebildeten Seitenflächen S₁ bis S₄ der Leiterplatte 2 zugeordnet. Die Ausbildung der Antenne 4 ist vergrößert der Schnittdarstellung der Figur 2 entnehmbar. Die Antenne 4 des dargestellten Ausführungsbeispieles ist U-förmig ausgebildet und umfaßt einen ersten Schenkel 6, der an jeder Seitenfläche S₁ bis S₄ der Leiterplatte 2 anliegt. Angeformt an diesen Schenkel 6 sind zwei parallel zueinander angeordnete weitere Schenkel 7, 7', die an der Oberseite 8 bzw. der Unterseite 9 der Leiterplatte 2 anliegen. Somit ist der Randbereich der Leiterplatte 2 durch die Antenne 4 eingefaßt.

Aus der Darstellung der Figur 1 wird deutlich, daß die durch die Antenne 4 aufgespannte Antennenfläche im Bezug auf die Leiterplatte 2 maximiert ist. Deutlich wird auch, daß die Oberseite 8 und die Unterseite 9 der Leiterplatte 2 bezüglich ihres Layouts und ihrer Bestückung konzipiert werden können, ohne auf diesen Flächen eine Antennenstruktur unterbringen zu müssen.

Vorteilhaft ist beim Gegenstand der Erfindung ferner, daß - wie in Figur 1 dargestellt - die Antennenfläche maximal ausgebildet werden kann und dennoch Bauteile unmittelbar am Rand der Platine positioniert werden können, wie dies in Figur 3 beispielhaft dargestellt ist. Bei dem in Figur 3 gezeigten Ausführungsbeispiel trägt eine Leiterplatte 2' ein elektronisches Bauteil B₄, beispielsweise eine LED. Die Antenne 4' dieser Leiterplatte 2' ist ausschließlich den Seitenflächen der Leiterplatte 2' zugeordnet, ohne daß sich wie bei dem Ausführungsbeispiel der Figuren 1 und 2 Antennenfortsätze über die Oberseite oder die Unterseite der Leiterplatte 2' erstrecken. Ohne Einbuße einer Antennenqualität kann jedoch auch bei dem in den Figuren 1 und 2 dargestellten Ausführungsbeispiel ein Bauteil unmittelbar am Rand der Platine 2 angeordnet sein. In diesem Fall würde im Bereich der Anordnung des randlich zu positionierenden Bauteils der Schenkel 7' der Antenne 4 im Bereich des zu positionierenden Bauteils eine Aussparung aufweisen.

Die Antennen 4, 4' werden dabei als galvanische Kupferbeschichtung ausgebildet.

### Bezugszeichenliste

- 1: elektronische Schaltungsanordnung
- 2, 2': Leiterplatte
- 3: Sende-Empfangseinrichtung
- 4, 4': Antenne
- 5, 5': Anschlußleiterbahn
- 6: Schenkel
- 7, 7': Schenkel
- 8: Oberseite
- 9: Unterseite

- B₁ - B₄: elektrisches Bauteil
- S₁ - S₄: Seitenfläche

## Patentansprüche

1. Elektronische Schaltungsanordnung, umfassend eine Leiterplatte (2, 2') mit einer Oberseite (8), einer Unterseite (9) sowie Seitenflächen (S₁, S₂, S₃, S₄), auf der ein eine Sende- und/oder Empfangseinrichtung beinhaltendes Bauteil (3) und eine an dasselbe angeschlossene Antenne (4, 4') angeordnet sind, wobei die Antenne (4, 4') bezogen auf ihre Längserstreckung zumindest abschnittsweise an mehreren Seitenflächen (S₁, S₂, S₃, S₄) der Leiterplatte (2, 2') diese aussenseitig abdeckend angeordnet und über zumindest eine Anschlußleiterbahn (5, 5') mit dem die Sende- und/oder Empfangseinrichtung beinhaltenden Bauteil (3) elektrisch verbunden ist, **dadurch gekennzeichnet, dass** die Antenne (4) durch eine galvanische Kupferbeschichtung der Seitenflächen (S₁, S₂, S₃, S₄) der Leiterplatte (2, 2') gebildet ist, wobei die Antenne in ihrem einer Seitenfläche zugeordneten Abschnitt eine L-förmige Querschnittsfläche aufweist, und wobei ein Schenkel der L-förmigen Querschnittsfläche der Antenne der Oberseite oder der Unterseite zugeordnet ist.

2. Elektronische Schaltungsanordnung, umfassend eine Leiterplatte (2, 2') mit einer Oberseite (8), einer Unterseite (9) sowie Seitenflächen (S₁, S₂, S₃, S₄), auf der ein eine Sende- und/oder Empfangseinrichtung beinhaltendes Bauteil (3) und eine an dasselbe angeschlossene Antenne (4, 4') angeordnet sind, wobei die Antenne (4, 4') bezogen auf ihre Längserstreckung zumindest abschnittsweise an mehreren Seitenflächen (S₁, S₂, S₃, S₄) der Leiterplatte (2, 2') diese aussenseitig abdeckend angeordnet und über zumindest eine Anschlußleiterbahn (5, 5') mit dem die Sende- und/oder Empfangseinrichtung beinhaltenden Bauteil (3) elektrisch verbunden ist, **dadurch gekennzeichnet, dass** die Antenne (4) durch eine galvanische Kupferbeschichtung der Seitenflächen (S₁, S₂, S₃, S₄) der Leiterplatte (2, 2') gebildet ist, wobei die Antenne (4) in ihrem einer Seitenfläche (S₁, S₂, S₃, S₄) zugeordneten Abschnitt eine U-förmige Querschnittsfläche aufweist, und wobei die beiden parallel zueinander angeordneten Schenkel (7, 7') der U-förmigen Querschnittsfläche der Antenne (4) der Oberseite (8) bzw. der Unterseite (9) der Leiterplatte (2) zugeordnet sind.

## Claims

1. Electronic circuit configuration comprising a printed circuit board (2, 2') with a top surface (8), a bottom surface (9) and lateral surfaces (S₁, S₂, S₃, S₄) on which are arranged a component (3) consisting of a transmitting and/or receiving device and an antenna (4, 4') connected to the same, for which purpose the antenna (4, 4') is arranged with its length positioned at least section-wise along a plurality of lateral surfaces (S₁, S₂, S₃, S₄) of the printed circuit board (2, 2'), covering the outer side of the same, and is electrically connected to the component (3) incorporating the transmitting and/or receiving device by means of at least one connecting conductor track (5, 5'), **characterised by the fact** that the antenna (4) is formed by an electro-plated copper coating of the lateral surfaces (S₁, S₂, S₃, S₄) of the printed circuit board (2, 2'), with the antenna having an L-shaped cross-sectional area in its section allocated to a lateral surface, and with one limb of the L-shaped cross-sectional area of the antenna allocated to the top surface or the bottom surface.

2. Electronic circuit configuration comprising a printed circuit board (2, 2') with a top surface (8), a bottom surface (9) and lateral surfaces (S₁, S₂, S₃, S₄), on which are arranged a component (3) consisting of a transmitting and/or receiving device and an antenna (4, 4') connected to the same, for which purpose the antenna (4, 4') is arranged with its length positioned at least section-wise along a plurality of lateral surfaces (S₁, S₂, S₃, S₄) of the printed circuit board (2, 2'), covering the outer side of the same, and is electrically connected to the component (3) incorporating the transmitting and/or receiving device by means of at least one connecting conductor track (5, 5'), **characterised by the fact** that the antenna (4) is formed by an electro-plated copper coating of the lateral surfaces (S₁, S₂, S₃, S₄) of the printed circuit board (2, 2'), with the antenna having a U-shaped cross-sectional area in its section assigned to one lateral surface (S₁, S₂, S₃, S₄), and with the two parallel-arranged limbs (7, 7') of the U-shaped cross-sectional area of the antenna (4) allocated to the top surface (8) or to the bottom surface (9) of the printed circuit board (2), respectively.

## Revendications

1. Circuit de commutation électronique comprenant une plaquette de circuits imprimés (2, 2') avec une face supérieure (8), une face inférieure (9) ainsi que des surfaces latérales (S₁, S₂, S₃, S₄) sur laquelle sont installés un composant (3), qui contient un système d'émission et / ou de réception, et une antenne (4, 4') qui est raccordé à celui-ci, l'antenne (4, 4') étant disposée, en ce qui concerne sont extension longitudinale, au moins par sections, sur plusieurs surfaces latérales (S₁, S₂, S₃, S₄) de la plaquette de circuits imprimés 2, 2'), en recouvrant celles-ci à l'extérieur, et étant électriquement reliée au composant (3) contenant le système d'émission et / ou de réception, par l'intermédiaire d'au moins une piste conductrice de raccordement (5, 5'), **caractérisé en ce que** l'antenne (4) est constituée par un revêtement de cuivre galvanique des surfaces latérales (S₁, S₂, S₃, S₄) de la plaquette de circuits imprimés (2, 2'), l'antenne présentant, dans sa section associée à une surface latérale, une surface de coupe transversale en forme de L, et une branche de la surface de coupe transversale en forme de L de l'antenne étant associée à la face supérieure ou à la face inférieure.

2. Circuit de commutation électronique comprenant une plaquette de circuits imprimés (2, 2') avec une face supérieure (8), une face inférieure (9) ainsi que des surfaces latérales (S₁, S₂, S₃, S₄) sur laquelle sont installés un composant (3), qui contient un système d'émission et / ou de réception, et une antenne (4, 4') qui est raccordé à celui-ci, l'antenne (4, 4') étant disposée, en ce qui concerne sont extension longitudinale, au moins par sections, sur plusieurs surfaces latérales (S₁, S₂, S₃, S₄) de la plaquette de circuits imprimés 2, 2'), en recouvrant celles-ci à l'extérieur, et étant électriquement reliée au composant (3) contenant le système d'émission et / ou de réception, par l'intermédiaire d'au moins une piste conductrice de raccordement (5, 5'), **caractérisé en ce que** l'antenne (4) est constituée par un revêtement de cuivre galvanique des surfaces latérales (S₁, S₂, S₃, S₄) de la plaquette de circuits imprimés (2, 2'), l'antenne (4) présentant, dans sa section associée à une surfaces latérales (S₁, S₂, S₃, S₄), une surface de coupe transversale en forme de U, et les deux branches (7, 7') de la surface de coupe transversale en forme de U de l'antenne, disposées parallèlement l'une par rapport à l'autre, étant associées à la face supérieure (8) respectivement à la face inférieure (9) de la plaquette de circuits imprimés (2).
